(19) Europäisches Patentamt
European Patent Office
Office européen des brevets

(11) **EP 2 108 971 A1**

(12) **EUROPEAN PATENT APPLICATION**

(43) Date of publication:
**14.10.2009 Bulletin 2009/42**

(51) Int Cl.:
*G01R 31/36* (2006.01)    *H02J 7/00* (2006.01)

(21) Application number: **08154433.0**

(22) Date of filing: **11.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Stichting IMEC Nederland**
**5656 AE Eindhoven (NL)**

(72) Inventors:
• **Pop, Valer**
**NL-5629 NV, Eindhoven (NL)**

• **Dolmans, Guido**
**NL-5651 RN  Son en Breugel (NL)**
• **Meynants, Guy**
**B-2470, Retie (BE)**

(74) Representative: **Sarlet, Steven Renaat Irène et al**
**Gevers & Vander Haeghen**
**Holidaystraat, 5**
**1831 Diegem (BE)**

(54)    **Autonomous system with estimation of remaining run-time by indirect measurement**

(57)    Autonomous system comprising a load circuit, an energy storage system (ESS) and an energy storage management system (ESM). The load circuit comprises a number of functional blocks providing a given functionality to the load circuit. The load circuit is powered by means of an electric current which varies over time depending on different circumstances. The ESS stores electric energy and is connected to the load circuit for supplying the varying electric current. The ESM is configured for estimating a remaining run-time of the autonomous system. To this end, the ESM comprises at least a first input for receiving a first parameter indicative of the varying electric current supplied from the energy storage system to the load circuit and is provided for determining the remaining run-time from this first parameter. The first parameter is an indirect measure for the varying electric current and is supplied by a first of the functional blocks of the load circuit.

**FIG. 5**

**Description**

**Technical field**

The present invention relates to an autonomous system according to the preamble of the first claim. In particular, the invention can be applied in the fields of wireless autonomous transducer solutions or portable devices.

**Background art**

Energy scavenging is the process of converting unused ambient energy into usable electrical power. Harvesting ambient energy, for example from light, mechanical vibrations, Radio-Frequency (RF) signals or temperature gradients, is very attractive for autonomous sensor networks. However, an energy storage system (ESS), i.e. a battery, supercapacitor or fuel cell, is always needed to store the energy obtained from the scavenger and to release it to the load when needed. This is important to autonomous systems, which do not allow ESS replacement or wired power coupling. As these energy-harvesting devices shrink in dimension, while still providing sufficient energy, they will be key enablers for autonomous wireless transducer systems. In order to increase the overall system efficiency a low-power energy storage management (ESM) system is very important.

ESS's basic task is to store energy obtained from the scavenger and to release it to the load when needed. In this case, accurate and reliable remaining run-time ($t_r$) indication is an important feature. For a linear ESS, e.g. a supercapacitor, the remaining run-time can be calculated when the capacity present in the supercapacitor and the current flowing out of the supercapacitor during discharge, are known. For an accurate estimate of the remaining run-time $t_r$, accurate estimations and updates of both parameters are desirable.

Not all ESS's are linear systems. An example of non-linear ESS is a battery. In this case, due to the battery overpotential a certain amount of capacity will remain stored inside the battery at the end of discharging. This value depends on many factors as *e.g.* discharge current, temperature, aging, *etc.*

More and more attention is paid to accurate State-of-Charge (SoC) and remaining run-time indication. Following the technological revolution and the appearance of more power-consuming devices on the automotive electronics, wireless autonomous and portable devices markets, the simple $t_r$ prediction systems based on voltage and temperature measurements, have been replaced by more complicated and accurate systems.

The method presented in US patent US 7208914 combines direct measurements with coulomb counting for determining the battery's SoC and the remaining run-time. In this case, the battery voltage, current, temperature and conductance parameters are measured by one or more Analog-to-Digital Converters (ADCs) and given as input to a SoC algorithm stored into the microcontroller. When small current values and high frequency current peaks need to be measured (this is the case for wireless autonomous sensor nodes), an accurate ADC with high-frequency sampling rates must be used. Such ADC consumes an important amount of power.

In patent application WO 9924842 the SoC and the remaining run-time are calculated based on a stored relation between the battery voltage and the SoC. Furthermore, it is shown in this patent that the battery voltage is also a function of the temperature and transmitter load current. As a result, voltage compensation with the battery temperature and transmitter load current is also calculated. This method is known to those skilled in the art as SoC calculation based on a look-up table.

In estimating $t_r$ for wireless autonomous sensor nodes, one is faced with the small value of the current and the high frequency current peaks from the radio module that may need to be measured. In prior art solutions in this field, accurate Analog-to-Digital Converters with high-frequency sampling rates are used in order to provide accurate current measurements. Such ADC's consume an important amount of power.

**Disclosure of the invention**

It is an aim of the invention to provide an autonomous system in which the power consumption needed for the remaining run-time estimation can be highly reduced.

This aim is achieved according to the invention with the autonomous system comprising the technical characteristics of the first claim.

The autonomous system according to the invention comprises a load circuit, an energy storage system (ESS) and an energy storage management system (ESM). The load circuit comprises a number of functional blocks providing a given functionality to the load circuit, i.e. the functional blocks are components whose primary function is to enable the load circuit to fulfil the functionality for which it is intended. The load circuit is powered by means of an electric current which varies over time depending on different circumstances. The ESS stores electric energy and is connected to the load circuit for supplying the varying electric current. The ESM is configured for estimating a remaining run-time of the autonomous system. To this end, the ESM comprises at least a first input for receiving a first parameter indicative of the varying electric current supplied from the energy storage system to the load circuit and is provided for determining the remaining run-time from this first parameter. According to the invention, this first parameter is an indirect measure for the varying electric current, i.e. it is not a current value which is directly measured. Furthermore, this first parameter is supplied by a first of the functional blocks of the load circuit.

An analysis of the problem of high power consumption in the prior art applications has shown that the high power consumption is caused by the use of a direct measurement for determining ESS parameters, such as for example a direct measurement of the supplied current, which requires most of the time extra circuitry. With the present invention, an indirect measurement of one or more parameters is used for determining the remaining run-time. For this indirect measurement, use is made of one of the functional components which are already present in the circuit design for enabling the functionality of the circuit; the addition of separate high power consuming measurement components can be avoided. In this way, the overall power consumption and the complexity of the load circuit can be highly reduced. Furthermore, this can eliminate the need for an ADC, which is a costly component.

In preferred embodiments of the invention, the first functional block which provides the first parameter is a control block for a second of the functional blocks which is mainly responsible for the varying of the electric current which is supplied by the ESS. In other words, this second block dominates the power consumption of the load circuit. The control block controls the regime in which the second block operates and can hence provide an indirect measure for the current which needs to be supplied to it and also the total current supplied to the load circuit, since the second block is dominant for this current.

An example of such a load circuit is when the second block is a variable gain amplifier comprising a plurality of stages which can be switched between an active mode and an inactive/bypass mode and the second block is provided for setting the number of active stages of the variable gain amplifier. In this case the number of active stages, which can be read from the first block, is the measure for the current which is discharged from the ESS.

In preferred embodiments of the invention, the autonomous system further comprises a means for measuring the load voltage of the energy storage system and/or a means for measuring the temperature of the energy storage system or a parameter indicative of this temperature. This information can be supplied to the ESM as second and third parameters which can be taken into account upon determining the remaining run-time and can lead to more accurate estimates. Again, an indirect measurement technique can be used, providing a low-power, accurate remaining run-time estimation without the need for extra circuitry.

For example, the means for measuring the load voltage can be provided by a comparison with a stable, independent reference voltage which is commonly generated in a voltage regulator. Such a voltage regulator can be used between an energy scavenger, which may be present in the autonomous system, and the ESS to ensure that the energy supplied by the scavenger is converted into a suitable voltage for charging the ESS. The means for measuring the temperature parameter can for example be provided by a component for generating a current proportional to the temperature. In this way, these parameters can be obtained from components already available in the system, avoiding the need for extra measurement circuits and unnecessary power consumption.

Taking load voltage and temperature into account has the advantage that the ESS aging process is considered in the run-time estimation. For instance ESS may loose performance during lifetime due to the increase in the impedance and due to the decrease in the maximum capacity. The changing rate in these two parameters is strongly dependent on the operational conditions. High C-rates for the (dis)charge currents and high temperatures and voltage levels during charging will speed-up the changing rate of these two parameters. As a result, the remaining run-time value estimated for an aged ESS under similar discharging conditions can be smaller than that of a fresh ESS. Subsequently, in order to enable accurate remaining run-time estimation even when the ESS ages, the use of an adaptive system can yield an important advantage.

In embodiments of the invention, the load circuit of the autonomous system comprises a radio and the parameters are wirelessly transmitted to the EMS. In this way, the invention can provide a low power ESM device which is particularly useful for wireless autonomous nodes, in particular wireless autonomous transducer systems (WATS).

The system of preferred embodiments of the present invention can provide a new approach for updating the estimating run-time of an ESS without the need for extra measurement circuitry. This is the overall advantage of the system. No extra ADC circuitry is needed for measuring the current, voltage and temperature. These parameters are measured indirectly by existing blocks which are already present in any wireless node, i.e. a radio and a voltage regulator (DC/DC converter). This can reduce the cost (by eliminating the need for an ADC) but also the consumed power and the complexity, resulting in a low-power wireless node. The accuracy can even be further improved through calibration of the remaining run-time to the voltage and temperature parameters. With an accurate and reliable remaining run-time indication all the available ESS capacity can be used and consequently, the autonomy of the wireless node system and the ESS lifetime can be increased.

**Brief description of the drawings**

The invention will be further elucidated by means of the following description and the appended figures.

Figure 1 shows a block diagram of a first embodiment of a WATS according to the invention.

Figure 2 shows a block diagram of the radio and its link towards the ESM of the WATS of figure 1.

Figure 3 shows a detail of the VGA of the radio of figure 2.

Figure 4 shows a radio system in general.

Figure 5 shows a block diagram of a second embodiment of a WATS according to the invention.

**Modes for carrying out the invention**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting of only components A and B. It means that with respect to the present invention, the only relevant components of the device are A and B.

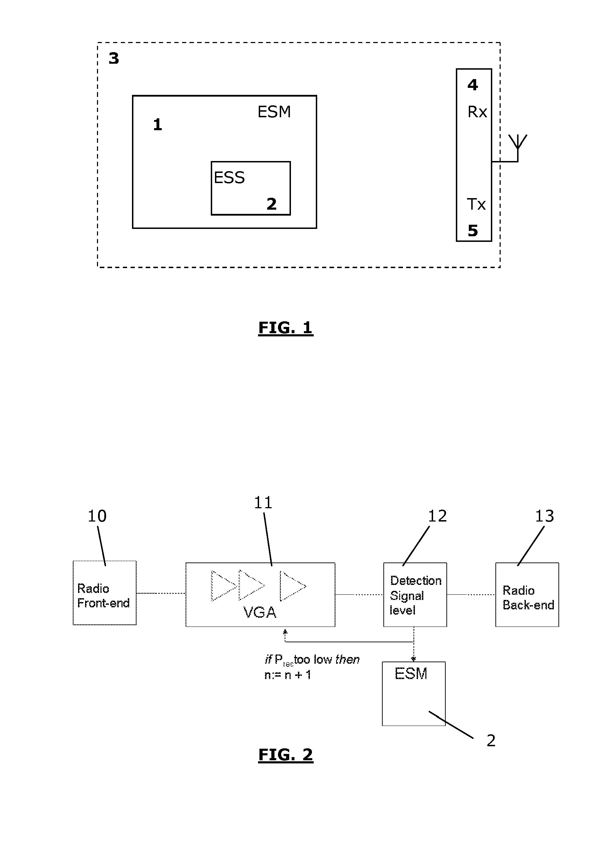

The present invention relates to a device and a method for estimating the remaining run-time of a battery/ storage device under a variety of conditions. The invention will be described in an implementation in a WATS that comprises of a radio system, but it is to be understood that the invention is more widely applicable. Fig.1 plots a block diagram of such system. The WATS (3) comprises an energy storage management device (ESM) (1) for estimating the remaining run-time of the energy storage system (ESS) (2) connected to the ESM during the discharge of the ESS. The radio of the WATS comprises a transmitter (5) and a receiver (4).

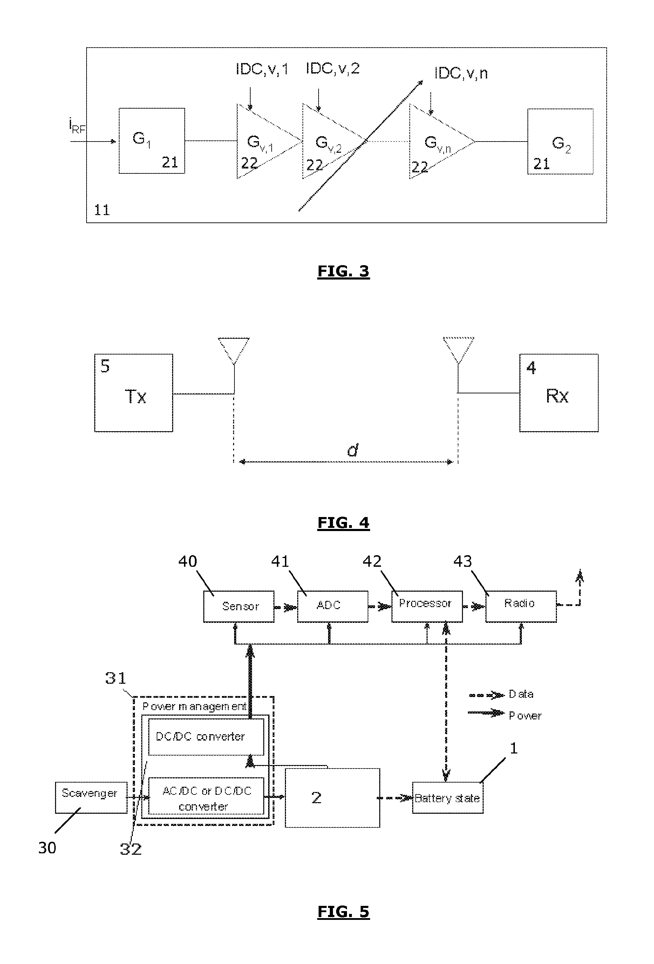

Fig.2 shows a block diagram of the radio and its link towards the ESM (1). The radio comprises a front-end (10), a VGA (11), a signal level detection block (12) controlling the VGA and a back-end (13). The VGA (11) comprises fixed stages (21) which are always active and switchable stages (22), as shown in fig.3. The signal level detection block (12) measures the strength of the received signal and provides feedback to the VGA (11) to switches stages (22) on/off to obtain a signal strength within a desired range. As a result, the strength of the received signal is indirectly related to the DC current consumption via the number of active VGA stages and the output of this detection unit (12) can be routed to the ESM unit (1) to provide a parameter which is an indirect measure of the current on the basis of which the ESM can determine an estimate of the remaining run-time. This technique can be used in the majority of wireless radio systems.

By measuring the load voltage and the temperature of the ESS, improved estimates of the remaining run-time can be calculated. Both parameters (voltage and temperature) can also be measured using indirect measurement techniques. This extra information can be extracted from signals already available in the WATS. No extra measurement circuitry is required, as will be described below and with reference to Fig.5.

The system makes use of the current ($I$) value estimated from the radio module and further more of the voltage ($V$) and temperature ($T$) values measured by the Direct Current / Direct Current (DC/DC) module (32), which is part of power management module (31). The measured values are used as input to the ESM system to calculate the ESS remaining run-time. In order to minimize the power the ESM system may also be implemented outside the wireless sensor node. In this case, the $V$, $T$ and $I$ values are transmitted to the ESM system through the radio module.

The power management module (31) is provided for converting the highly irregular energy flow from the scavenger (30) into regulated energy suitable to charge ESS (2) or to directly power the autonomous sensor network modules. ESS's basic task is to store energy obtained from the scavenger and to release it to the load when needed.

It is clear that accurate and reliable remaining run-time ($t_r$) indication is an important feature for the above described system, which may be calculated as follows. The remaining run-time for a linear ESS, *e.g.* a supercapacitor, may be calculated by using the following equation:

$$t_r[h] = \frac{Q_s[mAh]}{I_d[mA]} \qquad (1)$$

where $Q_s$ denotes the capacity present inside the supercapacitor (expressed in milli-Ampères hour) and $I_d$ the value of the current that flows out from the supercapacitor during discharging (expressed in milli-Ampères).

During discharging $t_r$ may be calculated by updating the $Q_s$ and $I_d$ values. The $Q_s$ update is made based on current measurements and integration, *i.e.* coulomb counting. It can be concluded from equation 1 and the observations given above that in order to accurately estimate the $t_r$ value an accurate current measurement is important.

In the case of non-linear ESS's, e.g. a battery, due to the battery overpotential [1], [2] a certain amount of capacity will remain stored inside the battery at the end of discharging. This value depends on many factors as *e.g.* discharge current, temperature, aging, *etc.*.

The remaining run-time for a non-linear ESS, e.g. a battery is calculated as follows:

$$t_r[h] = \frac{Q_b[mAh]}{I_d[mA]} \qquad (2)$$

where $Q_b$ denotes the capacity present inside the battery under the present discharge conditions.

As shown by equation 1 and 2, respectively, in order to calculate the remaining run-time several parameters need to be known. In a first case, in order to predict the remaining run-time for a supercapacitor system, the discharging current and the capacity present inside ESS need to be determined (see equation 1). As a possible solution, the supercapacitor maximum capacity $\left( Q_s^{\max} \right)$ may be measured and stored beforehand in the ESM system. As an example, the method presented in [3] may be used for this measurement. Afterwards, the supercapacitor capacity value may be updated during discharging by using the following equation:

$$Q_s = Q_s^{\max} - \Sigma I_d t_d \qquad (3)$$

where $t_d$ denotes the discharging time in hours.

In a second case, the capacity inside a battery under the present discharging conditions, denoted as $Q_b$, and $I_d$ need to be determined for estimating the remaining run-time of a battery system (see equation 2). Similar as for the supercapacitor, the maximum battery capacity $\left( Q_b^{\max} \right)$ may be determined and stored beforehand in the ESM system. Afterwards, the battery capacity available under the actual discharge conditions may be updated by

$$Q_b = Q_b^{\max} - \Sigma I_d t_d - Q_l \qquad (4)$$

where $Q_l$ denotes the capacity that can not be removed from the battery under the actual discharging conditions due to the battery overpotential.

A couple of shortcomings in the measurement, calibration, modelling and adaptive methods and in the equilibrium state detection have been revealed in [1]. In order to enable accurate remaining run-time prediction the discharge current needs to be accurately determined. The most common prior art method was to measure the current that flows out of an ESS by means of an ADC module [1], [2]. Furthermore, in order to enable accurate SoC and $t_r$ determination even when the battery ages, adaptive systems have been also developed. As an example, adaptive models for the maximum capacity ($Q_{max}$) and overpotential models have been presented. However, the use of this method required an important amount of power and consequently affected the overall efficiency of the wireless autonomous node. The prior art methods have been designed for high power portable devices, e.g. mobile phones, shavers, laptops and not for WATS.

According to the invention, a radio system can be considered which transmits signals over the air and receives these signals as outlined in Figure 4. The Rx module (4) receives an attenuated copy of the transmit signal (5). This attenuation will be determined by the distance $d$. For example, in free space communications, the input power to the Rx module will be attenuated by $d^2$. This means that the Rx module (4) will receive a very weak signal for a large separation between the two modules, e.g. $P_{rec}$ = -90 dBm for $d$ = 10m. On the other hand, the Rx module (4) receives a strong signal for a small separation between the two modules, $P_{rec}$ = -30 dBm for $d$ = 10 cm. In order to deal with this large dynamic range of input signals, the receiver comprises a gain block (11); fixed (21) and switchable VGA stages (22). This is shown in Figure 3.

The fixed gain blocks (21) $G_1$ and $G_2$ provide the minimal gain for correct radio operation when the input levels are strong. The $n$ switchable sections of the VGA will be activated when the signals become weaker. A possible strategy is to activate one extra section when the input signal $P_{rec}$ becomes weaker than the corresponding threshold. Consider that the dynamic range is subdivided in $n$ parts.

The total variable gain of the VGA can then be written as:

$$G_{var} = 1 \quad for \quad P_{max} - DR/n < P_{rec} < P_{max}$$

$$G_{var} = G_{v,1} \quad for \quad P_{max} - 2\,DR/n < P_{rec} < P_{max} - DR/n$$

$$G_{var} = G_{v,1}\,G_{v,2} \quad for \quad P_{max} - 3\,DR/n < P_{rec} < P_{max} - 2\,DR/n$$

$$.$$

$$.$$

$$G_{var} = G_{v,1}\,G_{v,2}\,..._{...}\,G_{v,n} \quad for \quad P_{max} - n\,DR/n = P_{min} < P_{rec} < P_{max} - (n\text{-}1)\,DR/n$$

$$(5)$$

where $P_{min}$ represents the minimum received power (e.g. -90 dBm) and $P_{max}$ represents the maximum received power (e.g. -30 dBm). The dynamic range DR is given by $P_{max} - P_{min}$.

The basic idea of the indirect current measurements of radio systems in this implementation is based on the relationship between DC current and the number of active VGA sections (22). The total current of the radio is given by the radio-frequency current $i_{RF}$ and the DC current $IDC$. The DC current is taken from the ESS (2) and is meant for generation of the RF current. The DC current will be much larger for an active VGA stage (22) than for an inactive (bypassed) VGA stage (22). We can write:

$$IDC = n\,IDC_{active} + (m\text{-}n)\,IDC_{bypass} \qquad (6)$$

where $n$ is the number of active stages and $m$ is the total number of switchable VGA stages (22). A typical value for $IDC_{active}$ is 3 mA while $IDC_{bypass}$ can be as low as 0.5 mA. Therefore, the current value retrieved from the radio will be dominated by the number of active sections $n$. Therefore, an indirect measure for the current value is obtained by counting the number of active stages $n$. This information is available in the software controlling the radio system, represented as block (12) in figure 2. One possible implementation is to use a look-up table of current values versus n for a particular radio system. An additional advantage is that the number of active stages $n$ gives an indication of the distance $d$ between the transmitter and the receiver. This can be explained by the fact that increasing the gain of the VGA means that the received input level is decreasing, which comes from an increased distance $d$.

It can be concluded from the observations given above, that the remaining run-time value is continuously updated during discharging by means of the current value retrieved from the radio module. In this case, as the radio module is the dominant consuming power module in wireless autonomous sensor networks, accurate remaining run-time estimation can be enabled.

The above equations 2, 3 and 4 lead to accurate $t_r$ estimation when the discharging starts from a complete full ESS. In order to further provide accurate remaining run-time prediction under an extended range of conditions the same estimation is possible from any other initial condition also. For this, the ESS capacity value is continuously updated and stored in the ESM system. So, at the beginning of each discharge the ESS maximum capacity is replaced by an updated capacity value that results from equations 3 and 4, respectively.

In order to further improve accuracy in $t_r$ estimation, measurement of other ESS characteristics, *e.g.* voltage and temperature, can be used. As an example, information about the ESS voltage may be used to calculate the initial capacity value or to compensate for the self-discharge [1], [3]. This compensation may be crucial for a supercapacitor system where the self-discharge rate is high. Furthermore, information about the ESS temperature may be used to correct the self-discharge rate, maximum capacity and $Q_l$ values [1].

As mentioned above, ESS and load voltage and system temperature can be extracted from the voltage regulator or a diagnostic circuit in the wireless autonomous node [4]. The wireless autonomous node will typically contain in the power management block (31) (see Figure 5) a voltage regulator (32) to adjust the supply voltage of the load. Any voltage converter requires a voltage reference circuit. Such circuit generates a stable voltage, which is not dependent on its own supply voltage or on the temperature of the circuit. A typical implementation is a bandgap reference circuit. Such circuit compensates the temperature dependency of the transistor threshold voltage by using complementary component which has a temperature coefficient of opposite sign. The complementary component can be a MOS transistor of opposite polarity, a diode or a bipolar transistor. In order to generate the right temperature compensation, a current is created which is proportional to absolute temperature (PTAT). This current can be measured and is available in the system as an estimate of the silicon temperature of the DC/DC converter circuit. Voltages (of ESS or load) can be measured by comparing this voltage, or an attenuated version of it, to the reference voltage generated by the bandgap circuit.

As previously mentioned the accuracy of the $t_r$ indication system can be affected by the ESS aging process. The ESS may loose performance during lifetime due to the increase in the impedance and due to the decrease in the maximum capacity. A simple method to deal with the maximum capacity decrease effect is the following. An update of

the $Q_{max}$ value $\left( Q_{\max}^{new} \right)$ is applied when the ESS voltage reaches the cut-off value. In this case, the following equation may be applied:

$$Q_{\max}^{new} = Q_{\max}^{old} - I_d \left( t_r^p - t_r^m \right) \qquad (7)$$

where $t_r^p$ and $t_r^m$ denote the predicted and measured $t_r$, respectively. Furthermore, $Q_{\max}^{old}$ denotes the old $Q_{max}$ value. In order to avoid big inaccuracies a factor between the $Q_{\max}^{new}$ and $Q_{\max}^{old}$ values of maximum 1.5 may be accepted for this update.

As mentioned above, a possible embodiment of the idea to pass the radio DC current consumption to the ESM unit is given in Figure 2. Another possible embodiment of the idea is to further pass the V and T measurement from the DC/DC converter directly to the ESM system, as shown in Figure 5. The system shown here contains two types of lines for data (dashed line) and power (continuous line) transmission. The system input power is delivered by the scavenger (30) and energy storage system combination. Possible load modules are the sensor (40), Analog-to-Digital Converter (ADC) (41), processor (42) and radio (43). Furthermore, in order to save power the ESM system (1) may be implemented outside the wireless autonomous sensor node. In this case, the V, I and T measurements can be sent to the ESM system through the radio module (43).

The following references are mentioned above and are hereby incorporated by reference in their entirety:

[1] V. Pop, Universal State-of-Charge Indication for Portable Applications, Ph.D. thesis, University of Twente, (2007)
[2] H.J. Bergveld, W.S. Kruijt, P.H.L. Notten, Battery Management Systems - Design by Modelling, Philips Research Book Series, 1, Kluwer Academic Publishers, Boston, (2002)
[3] V. Pop, Energy storage systems integration on the IMEC-NL platforms, Technical Note TN-07-1-03-001 (2007)
[4] Violeta Petrescu, Marcel Pelgrom, Harry Veendrick, Praveen Pavithran and Jean Wieling, A Signal-Integrity Self-Test Concept for Debugging Nanometer CMOS ICs, Proc. International Solid State Circuit Conference, 544-545 (2006)

**Claims**

1. An autonomous system (3) comprising:

a load circuit (4-5; 40-43) comprising a number of functional blocks providing a given functionality to said load circuit, said load circuit requiring a varying electric current during performance of said functionality,

an energy storage system (2) for storing electric energy, connected to said load circuit for supplying said varying electric current thereto, and

an energy storage management system (1) for estimating a remaining run-time of the autonomous system, said energy storage management system comprising at least a first input for receiving a first parameter indicative of said varying electric current supplied from said energy storage system to said load circuit and being provided for determining said remaining run-time from said first parameter,

**characterized in that** said first parameter is an indirect measure for said varying electric current and is supplied by a first of said functional blocks (12; 42).

2. An autonomous system according to claim 1, wherein said functional blocks comprise a second block (11; 41) which is mainly responsible for the varying of said electric current, the first block being a control block for controlling said second block.

3. An autonomous system according to claim 2, wherein said second block (11; 41) is a variable gain amplifier comprising a plurality of stages (22) switchable between an active and an inactive mode, said first block (12) being provided for setting the number of active stages of said variable gain amplifier, said first parameter being said number of active stages.

4. An autonomous system according to any one of the previous claims, wherein said system comprises a means (32) for measuring a load voltage over said energy storage system (2), said load voltage being supplied as a second parameter to said energy storage management system (1) which is provided for taking said load voltage into account upon determining said remaining run-time.

5. An autonomous system according to any one of the previous claims, wherein said system comprises a means (32) for measuring a third parameter indicative of the temperature of said energy storage system (2), said third parameter being supplied to said energy storage management system (1) which is provided for taking said third parameter into account upon determining said remaining run-time.

6. An autonomous system according to any one of the previous claims, wherein said system further comprises an energy scavenger (30) as an energy source and a voltage regulator (32) for converting the energy supplied by said energy scavenger (30) to a suitable voltage for charging said energy storage system.

7. An autonomous system according to claims 4 and 6, wherein said load voltage measuring means is provided for measuring the load voltage by comparison with a stable reference voltage generated in the voltage regulator.

8. An autonomous system according to claims 5 and 6, wherein said third parameter measuring means is provided by a component for generating a current proportional to the temperature.

9. An autonomous system according to any one of the previous claims, wherein said load circuit comprises a radio (4-5; 43) and each of said parameters is wirelessly transmitted to said energy storage management system (1).

10. An autonomous system according to any one of the previous claims, wherein said autonomous system is a wireless autonomous transducer system.

**3**

**1** ESM

ESS

**2**

**4**
Rx

Tx
**5**

**FIG. 1**

10

11

12

13

Radio
Front-end

VGA

Detection
Signal
level

Radio
Back-end

*if* P$_{rec}$ too low *then*
n := n + 1

ESM

2

**FIG. 2**

**FIG. 3**

**FIG. 4**

**FIG. 5**

Europäisches
Patentamt

European
Patent Office

Office européen
des brevets

**EUROPEAN SEARCH REPORT**

Application Number

EP 08 15 4433

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 847 566 A (MARRITT WILLIAM A [JP] ET AL) 8 December 1998 (1998-12-08) <br> * column 11, line 29 - column 14, line 4; figures 1-3 * <br> * column 38, line 45 - line 46 * <br> * column 53, lines 1-10 * <br> ----- | 1-10 | INV. <br> G01R31/36 <br> H02J7/00 |
| X | US 2004/117137 A1 (JIN XIN [CA] ET AL) 17 June 2004 (2004-06-17) <br> * paragraph [0001] - paragraph [0005]; figures 1,2 * <br> * paragraph [0033] - paragraph [0034] * <br> ----- | 1-5,9,10 | |

TECHNICAL FIELDS
SEARCHED     (IPC)

G01R
H02J

The present search report has been drawn up for all claims

| Place of search | Date of completion of the search | Examiner |
|---|---|---|
| The Hague | 23 September 2008 | Koll, Hermann |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 ...........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 08 15 4433

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2008

| Patent document cited in search report | | Publication date | Patent family member(s) | | Publication date |
|---|---|---|---|---|---|
| US 5847566 | A | 08-12-1998 | CN<br>JP | 1126320 A<br>8136626 A | 10-07-1996<br>31-05-1996 |
| US 2004117137 | A1 | 17-06-2004 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7208914 B

- WO 9924842 A

**Non-patent literature cited in the description**

- **V. Pop.** Universal State-of-Charge Indication for Portable Applications. *Ph.D. thesis,* 2007
- **H.J. Bergveld ; W.S. Kruijt ; P.H.L. Notten.** Battery Management Systems - Design by Modelling, Philips Research Book Series. Kluwer Academic Publishers, 2002, vol. 1

- **V. Pop.** Energy storage systems integration on the IMEC-NL platforms. *Technical Note TN-07-1-03-001,* 2007
- **Violeta Petrescu ; Marcel Pelgrom ; Harry Veendrick ; Praveen Pavithran ; Jean Wieling.** A Signal-Integrity Self-Test Concept for Debugging Nanometer CMOS ICs. *Proc. International Solid State Circuit Conference,* 2006, 544-545